# EUROPEAN PATENT APPLICATION

(11) **EP 0 558 984 A2**
(43) Date of publication of application: **08.09.1993**
(21) Application number: 93102332.9
(22) Date of filing: 15.02.1993
(51) Int. Cl.: H01L 25/16, H01L 23/538, H01L 23/64

(54) **Hybrid ceramic thin-film module structure**

(30) Priority: 06.03.1992 US 847461
(71) Applicant: INTERNATIONAL BUSINESS MACHINES CORPORATION, Armonk, N.Y. 10504 (US)
(72) Inventor: Deutsch, Alina, Chappaqua, New York 10514 (US); Nealon, Michael Gerard, Peekskill, New York 10566 (US); Rubin, Barry Jay, Croton-on-Hudson, New York 10520 (US)
(74) Representative: Teufel, Fritz, Dipl.-Phys.

(57) **Abstract**

Structure is disclosed for a hybrid, ceramic thin-film semiconductor module package having signal lines with two resistance levels in the same plane-pair that have the same characteristic impedance and satisfy the constraints on allowed coupled noise. The package includes a ceramic base and a thin-film module. Both low (wide lines) and high resistance (narrow lines) X-Y thin-film transmission lines are contained in the thin-film layers of the hybrid module with a minimum number of the thin-film layers. The signal lines are referenced to thin-film ground-planes and there are redistribution lines in both a top surface layer and under the X-Y wiring in a normalization layer.

## Description

The present invention relates to semiconductor package structures, and more particularly to module packages having signal lines contained in a hybrid module structures.

The following representative publications discuss the general field of semiconductor package structures.

U.S. Patent 4,322,778 issued March 30, 1982 to Barbour et al entitled "HIGH PERFORMANCE SEMICONDUCTOR PACKAGE ASSEMBLY" describes an improved high performance semiconductor package assembly for interconnecting a plurality of integrated circuit devices having a multilayer substrate with internal wiring including signal wiring and external signal and power connections, a plurality of integrated circuit semiconductor devices supported on the top surface of substrate in electrically connected operative relation, the improvement being a power supply distribution system for providing electrical supply voltages to the devices from the power connections consisting of radial waveguide structure including parallel waveguide planes with a low input impedance to reduce switching noise, the waveguide planes located between the signal fan-out wiring and internal wiring metallurgy and connected in common to all of the plurality of devices.

U.S. Patent 4,446,447 issued May 1, 1984 to Corrie et al entitled "MULTICHIP THIN FILM MODULE" describes a structure wherein a novel thin film processing substrate is embodied into a multichip hybrid module. The processing substrate is provided with conductive vias which are arranged in an area array having the same pattern as the lead out pin vias on a base substrate. The top surface of the processing substrate is built up by thin film techniques to provide a laminate thereon comprising a ground plane and a plurality of thin film X-direction and Y-direction signal distribution lines separated one from the other by thin polyimide insulating layers. The interconnecting thin film lines and polyimide layers are built up as patterns using photolithographic techniques. The X and Y-direction conductive lines and the ground plane are selectively interconnected through the vias and each other to form a predetermined signal distribution circuit. Terminal pads are provided on both the X and Y-direction lines to permit making electrical interconnections to the integrated circuit chips which are mounted on the processing substrate thus forming a circuit pattern between the integrated circuit chips and the lead out pins on the base substrate. Bumps are provided on the top of the vias in the base or pinned substrate for connecting it to the processing substrate after the integrated circuit chips have been mounted thereon.

U.S. Patent 4,465,727 issued August 14, 1984 to Fujita et al entitled "CERAMIC WIRING BOARDS" describes a ceramic wiring board which comprises ceramic part in which through-holes are made, sintered wiring pattern part provided on the surface of said ceramic part and sintered conductor part filled in said through-holes shows much decrease in cracks at the through-hole part caused by sintering and remarkable reduction in moisture absorbency when the ceramic part comprises ceramic containing a sintering assistant and the sintered conductor part comprises a metal containing the same sintering assistant as that present in said ceramic part.

U.S. Patent 4,641,425 issued February 10, 1987 to Dubvission et al entitled "METHOD OF MAKING ALUMINA INTERCONNECTION SUBSTRATE FOR AN ELECTRONIC COMPONENT" describes a structure wherein a substrate is formed by a stack of sheets of dielectric material at least some of which conductive patterns thereon; the substrate has conductive emerging portions for connecting the terminals of the component to at least one internal layer provided with conductive tracks providing layer-to-layer interconnection and interconnection with emerging portions in accordance with a pre-established patterns. According to the invention, the composition of the dielectric material comprises 92% to 98% of alumina, and preferably 96%, with a melting agent based on magnesia titanate enabling the maximum firing temperature to be reduced to about 1400:f.degree:ef.C. The conductive patterns are made of a non-oxidizable metal which is not meltable at high temperature, e.g. palladium or a silver-palladium alloy. The properties of the substrate obtained in this manner are comparable to those of a substrate made of 99.9% ultra-pure alumina. The invention is also applicable to multi-level chip carriers made of this material.

U.S. Patent 4,649,417 issued March 10, 1987 to Burgess et al entitled "MULTIPLE VOLTAGE INTEGRATED CIRCUIT PACKAGING SUBSTRATE", a structure wherein a multilayer ceramic integrated circuit packaging substrate provides a plurality of integrated circuit operating voltages at the integrated circuit mounting surface thereof without requiring a separate input/output pin and internal power distribution plane for every integrated circuit operating voltage. The substrate includes a power via for supplying a first integrated circuit operating voltage at the integrated circuit mounting surface, and a plurality of voltage converting means on the integrated circuit mounting surface for stepping down the first operating voltage to all other requisite operating voltages. The voltage converting means may be resistors or operational amplifier voltage dividers.

U.S. Patent 4,736,521 issued April 12, 1988 to Dohya entitled "PROCESS FOR MANUFACTURING A CERAMIC MULTI-LAYER SUBSTRATE" discloses a multi-layer structure comprising a multi-layer glass ceramic substrate and a multi-layer wire line matrix. The multi-layer wired line matrix includes an insulating layer made from a photosensitive insulating layer, amenable to time geometry processing. The insulating layer of the multi-layer wire line matrix has a pad for accommodating variations of the locations of the through holes. The metal is plated in and fills the through holes so that the metal is not cut off at the corners. The wire line matrix is composed of a plurality of layers of a photo-lithographically formed fine conductive pattern. The glass ceramic insulating layer is also formed photo-lithographically, and is formed of the source material of the insulating layers.

U.S. Patent 4,800,459 issued January 24, 1989 to Takagi et al entitled "CIRCUIT SUBSTRATE HAVING CERAMIC MULTILAYER STRUCTURE CONTAINING CHIP-LIKE ELECTRONIC COMPONENTS" describes a circuit substrate comprising a ceramic laminated structure which has a plurality of ceramic layers including ceramic layers having cavities. Chip-like electronic components such as a laminated ceramic capacitor and a resistor are received in the cavities. The chip-like electronic components are formed with external terminal electrodes respectively. Conductors are formed in through holes provided in the ceramic layers and interfaces between adjacent pairs of the ceramic layers, to be connected to the external terminal electrodes. The external terminal electrodes are prepared from metal which is mainly composed of at least one of nickel, copper and palladium, and the conductors are prepared from metal which is mainly composed of copper.

U.S. Patent 4,827,327 issued May 2, 1989 to Miyauchi et al entitled "INTEGRATED CIRCUIT DEVICE HAVING STACKED CONDUCTIVE LAYERS CONNECTING CIRCUIT ELEMENTS THERETHROUGH" discloses an integrated circuit device including a stacked layer unit having a plurality of stacked layers each having an insulation layer and at least one conductive layer strip formed on a surface of the insulation layer, and at least one chip mounted on the top of the insulation layer and having a plurality of circuit elements. The IC device also includes at least one first conductive member formed in the stacked layer unit, having a low inductance for first signals applied thereto and operatively connecting the first signals to be transferred between the circuit elements. The IC device further includes at least one second conductive member formed in the stacked layer unit, having a higher inductance for the first signals than that of the first conductive member and operatively connecting second signals to be transferred between the circuit elements the stacked layer unit, and the first and second conductive members are enclosed by a package and sealed with a hermetic seal.

The IBM Technical Disclosure Bulletin, Vol. 22, No. 8A, January 1980, pages 3406-3409 contains a publication by C.W. Ho et al entitled "FABRICATION OF MULTIPLE LSI SILICON CHIP MODULES" which describes high speed chip modules having power planes laminated into a single bus.

The IBM Technical Disclosure Bulletin, Vol. 21, No. 5, October 1978, pages 1895-1897 contains a publication by S. Magdo entitled "INDUCTANCE MODULE" that discloses a low inductance two layer ceramic module wherein all the signal lines are formed out on top of the module to the lead frame.

The IBM Technical Disclosure Bulletin, Vol. 20, No. 6, November 1977, pages 2221-2222 contains a publication by J.A. Benenati entitled "SEMICONDUCTOR MODULE" describes a semiconductor package structure for supporting chips wherein coupled noise between lines on the top surface fan-out pattern from the chip to the I/O vias is reduced by having a ground plane below the signal lines.

High performance computers often employ ceramic modules that have conductors and vias made through thick-film structure technology. Advances in integration density and circuit switching speeds, however, may require corresponding improvements in module wiring density and propagation delay not achievable through such thick-film technology. Thin-film structures offer fine line sizes and smaller propagation delays because of lower dielectric constant materials, but they have signal line resistances not compatible with present computer circuits.

The limitations with the thick-film ceramic module involve the signal wiring density and propagation delay. The present thick-film technology provides one line per channel, where the channel spacing is 0.45 mm, and require about 8-14 x-y signal plane pairs. Because of metallurgical (conductor paste composition), process, and electrical design considerations (resistance, characteristic impedance, and coupled noise) inhibit increased wiring density.

Propagation delay, a major contributor to overall net delay, is essentially determined by the high dielectric constant of the ceramic material compared to thin-films.

The width of thin-film lines, limited only by photolithographical constraints, may be made small enough to wire an entire module on a single x-y plane pair. However, computer systems require at least some terminated signal lines and thus the signal lines may carry large currents and have significant DC drops. A signal line, even one of pure copper, having the line cross-section required for such wiring density would yield an unacceptably high resistance. For example, a thin-film system, with lines having width 8 micrometer and thickness 6 micrometer, has a resistance about eight times that of the currently accepted values. If the lines were made larger, consistent with other electrical constraints, the number of x-y layers would make such a thin-film module impractical.

In the present invention, a structure is provided including a ceramic module as a base for pins, power distribution, and some signal layers and thin-film layers on top of the ceramic base to handle a significant portion of the module wiring, especially the machine cycle time determining nets.

An object of the invention is to provide a hybrid ceramic, thin-film module composed of a ceramic module base and a minimal number of thin-film layers that is compatible with computer circuit design.

Another object of the present invention is to provide a hybrid ceramic thin-film module including a surface thin-film wiring layer for redistribution and power busing functions.

A further object of the present invention is to provide a hybrid ceramic, thin-film module including at least one thin-film ground plane for shielding lines in wiring layers from other lines and for transmission-line reference.

Still another object of the present invention is to provide a hybrid, ceramic, thin-film module including a normalization layer having metal pads at the ceramic, thin-film interface.

Fig. 1 is a schematic illustration of a cross-section of an embodiment of a hybrid ceramic and thin-film module according to the principles of the present invention including a ceramic base and a plurality of thin-film layers.

Fig. 2 is a schematic illustration of the top surface metallurgy of the uppermost thin-film layer of a hybrid module structure according to the principles of the present invention.

Fig. 3 is a schematic illustration of redistribution paths disposed on a normalization layer of a hybrid module structure.

Fig. 4 is a schematic illustration of a cross-section of a wiring channel of a thin-film including three lines located within thin-film vias.

Fig. 5 is a schematic illustration showing the use of unused, dead zones on a thin-film for wiring.

Fig. 6 is a schematic illustration of a wiring design with three lines between via positions.

Fig. 7 is a schematic illustration of a cross-section of thin-film layers on top of ceramic wiring.

Fig. 8 is a plan view of a mesh reference plane.

Fig. 9 is a schematic illustration of a plan view of narrow and wide lines arranged in regularly spaced channels in-between two thin-film ground planes where the islands in the planes are interconnected by a minimum number of mesh straps.

Fig. 10 is a schematic illustration of a cross section of an embodiment of a layout for a three lines per channel wiring design.

Fig. 11 is a schematic illustration of a wiring scheme for a hybrid module of the present invention compared with a typical wiring scheme for a conventional ceramic module.

Structure is described for ceramic thin-film module packages having signal lines with two resistance levels in the same plane-pair that have the same characteristic impedance and satisfy the constraints on allowed coupled noise. Both low (wide lines) and high resistance (narrow lines) X-Y thin-film transmission lines are contained in a hybrid module with minimum number of thin film layers. The signal lines are referenced to a thin film ground-plane and there are redistribution lines in both a top surface layer and under the X-Y wiring in the normalization layer.

The embodiment shows a possible design with three lines between via positions and the cross section of the thin film layers on top of the ceramic wiring. The narrow and wide lines run in a preassigned regular pattern of channels. The use of two thin-film ground planes assures that the X and Y layer lines have the same impedance and can be referenced to two different voltages which is compatible with the method used in the plane-pairs in the ceramic wiring. The thin film signal lines are shielded from and thus not affected by the redistribution or normalization layers.

The redistribution lines in the normalization layer having the bottom ground reference plane close to them can be designed to have less coupled noise and the same Z₀ as the ones in the top surface layer.

The characteristic impedance for narrow and wide lines is maintained the same by opening regularly spaced channels in the two thin-film ground planes where the wide lines are used and leaving a pseudo-mesh only.

The islands in the planes are interconnected by a minimum number of mesh straps that maintain a good DC conductivity, provide a low inductance return path for the narrow lines but do not capacitively load the wide lines to reduce their impedance. The straps enhance the shielding of the X and Y signal lines from coupled noise generated in the redistribution layers. Having these mesh channels preassigned makes the use of either type of lines transparent to the routing programs.

The thickness of the dielectric layers which is one of the parameters determining Z₀ is then dictated by the narrow lines. Consequently, the polyimide can be deposited by spin coating, possibly in multiple steps. In order to maintain low line resistance, the copper thickness is substantial but known techniques may be used such as lift-off combined with a redundant metal deposition where the same metal pattern is repeatedly evaporated in several steps.

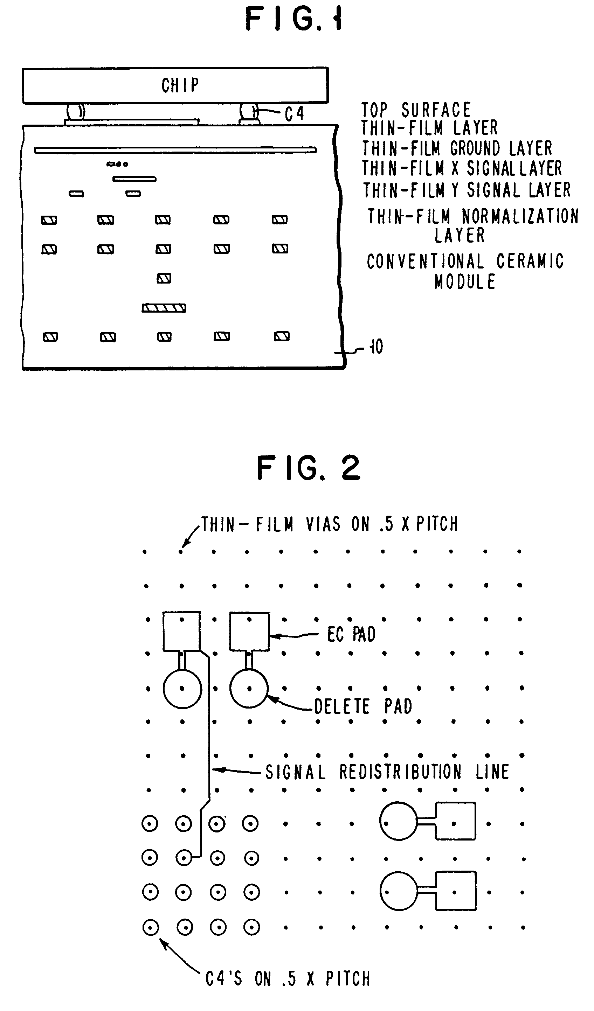

In Fig. 1, a cross-sectional view of the hybrid module is depicted. The module is a hybrid because it consists of an upper thin-film section and a lower ceramic section. The ceramic region contains a conventional multi-layer ceramic substrate used for voltage distribution and signal interconnections. The thin-film section consists of multiple levels of photolithographically defined thin-film wiring. Logic and memory chips are joined to the hybrid module through solder C4 (Controlled Collapseable Chip Connection) balls.

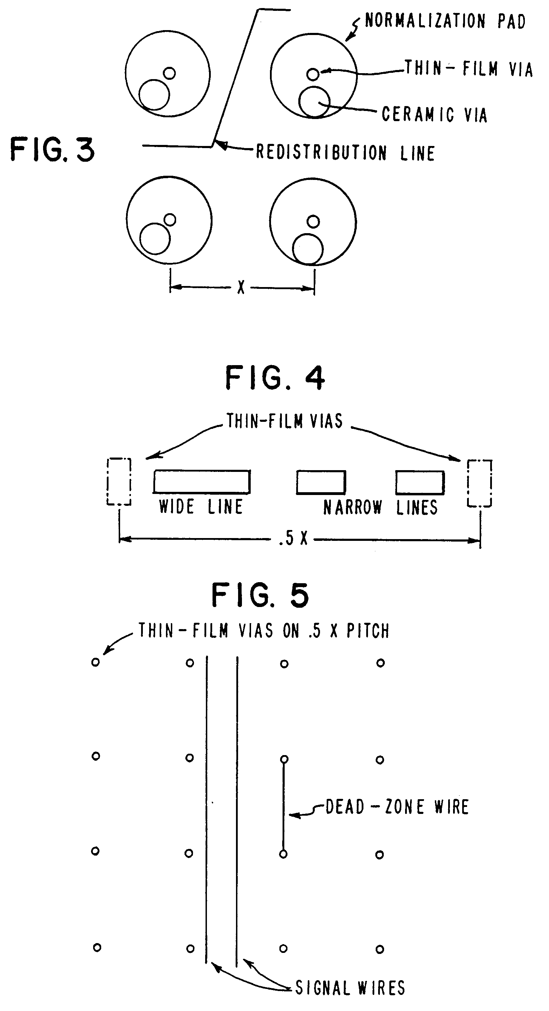

The C4 pad grid is a submultiple of X, the ceramic module via and wiring grid (0.5X for example). The top surface thin-film layer contains C4 pads, EC (engineering change) pads and thin-film redistribution wiring as shown in Fig. 2. EC lines are wires that can be used to reroute circuit-to-circuit interconnections in the modules. For the module to be 100% EC'able each signal C4 must be connected to an associated top surface EC pad. To accomplish this, thin-film redistribution wiring is used to make the majority of these connections. The remaining redistribution lines can be included in the normalization layer shown in Figs. 1 and 3. The normalization layer is comprised of normalization pads used to capture the ceramic vias. The sizes of these pads are dependent upon spatial distortion caused by non-uniform shrinkage of the ceramic material. Making the pad large enough to ensure the ceramic vias are captured normalizes the processing of the remaining thin-film layers. The remaining redistribution wiring is then wired out in between the normalization pads.

Achieving all redistribution wiring in the thin-film is especially important when large number of voltage vias are necessary under the chip footprint depleting the supply of connections to the ceramic studs that are on a coarser grid. This allows these ceramic via locations to be used for voltage vias which provide for a uniform chip power distribution network, reducing variation in power supply at the chip level, reduced switching noise and reduced coupled noise between studs and vias. This is especially important for Bipolar technologies, which have high slew rates and may use as many as four different power supply voltage levels.

A novel design option is that the top surface pattern and the normalization pattern can be used with and without the thin-film X-Y plane pair. As shown in Fig. 2 with the thin-film vias and C4's on 0.5X grid every top surface pad is captured by at least one thin-film via. Since all C4 to EC wiring is provided for on these two layers, the module remains 100% EC'able and all the function is maintained. This would provide the flexibility of going to a lower cost, lower performance option, using essentially the same design.

The thin-film interconnection wiring structure consists of an X and Y directional wiring layers sandwiched between two voltage reference-planes. The plane-pair structure can be designed to provide a controlled impedance and coupled noise environment. The redistribution wiring on the top surface and normalization layer have minimum coupled noise due to the presence of the voltage planes (Fig. 1). The thin-film offers increased wiring channels in comparison to the conventional ceramic. Fig. 4 shows a possible thin-film wiring structure with three lines between the thin-film vias (0.5X grid). This effectively provides for the equivalent of 6 ceramic wiring plane-pairs of wiring grid X. This allows for the majority of the critical performance nets that determine the machine cycle time to be wired in the faster medium with a lower relative dielectric constant, εᵣ, (εᵣ = 3.5 versus 9.5 and 5.0 for alumina and glass ceramics, respectively). This provides a 65% and 20% faster propagation delay than alumina and glass ceramic media, respectively.

The via connections to the X-Y wiring from either the ceramic or the top surface are made on the 0.5X thin-film via grid. All X-Y wiring can be connected using vias placed at any location which is made possible by the high density photolithographic thin-film fabrication process as described by J. Paraszczak, et al, "Fabrication and Performance Studies of Multilayer Polymer/Metal Interconnect Structures for Packaging Applications", proceed. ECTC'91, pp. 362-369, May 1991, Atlanta. Such vias are referred to as interstitial because they can be placed in the wiring channels, between the thin-film vias shown in Fig. 4. On the thin-film X-Y layers the region between the vias, where long channels are blocked (called dead zones), short signal jogs can be used for changing directions as well (Fig. 5). The dead zone wiring can also be used for power distribution as well. This again is advantageous for Bipolar technologies having more than two voltages since it is very costly to provide more than two-voltage reference-planes in the thin-film section. Use of the dead zone wiring region for the remaining voltage levels reduces the need for ceramic voltage redistribution.

The thin-film wiring configuration shown in Fig. 4 contains three lines of varying widths. Wider lines, with lower resistance, can be used for long terminated nets (maximum length limited by maximum allocated DC drop), as discussed by R.R. Tummala and E.J. Rymaszewski, "Microelectronics Packaging Handbook", Van Nostrand Reinhold, New York, 1989, long unterminated nets (attenuation-limited), described by A. Deutsch, G.V. Kopcsay, et al, "High-speed Signal Propagation on Lossy Transmission Lines", IBM J. Res. Develop., Vol. 34, pp. 601-615, July 1990, or unterminated nets with multiple receivers (capacitive-loading-limited). The narrow lines are used for nets not sensitive to DC drop (unterminated nets) and short terminated nets. This is a novel method of offering the system designer additional flexibility for power/performance tradeoffs.

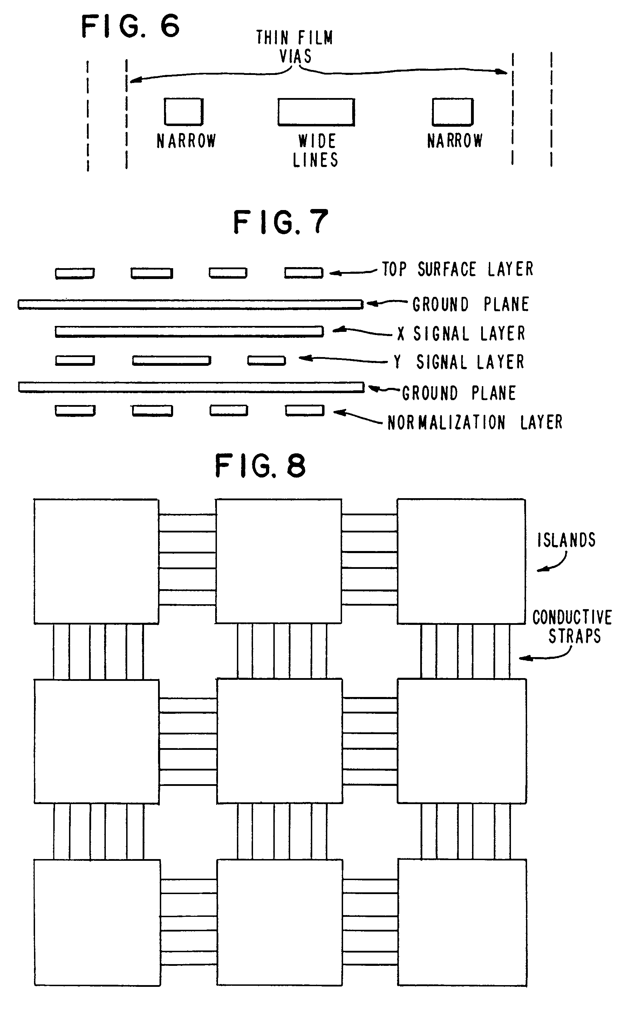

Figs. 6-10 show a possible implementation of the thin-film wiring structure for both terminated and unterminated nets contained within the same plane-pair. All the lines have equal characteristic impedance Zo. Narrow and wide lines (Fig. 6) run in preassigned regular pattern of channels which makes the use of either type transparent to routing programs. Two thin-film reference-planes (Fig. 7) assure a controlled impedance for both the X and Y lines. The reference planes shield the X and Y layers from the top redistribution and bottom normalization layers, providing a means of designing these layers with the same characteristic impedance.

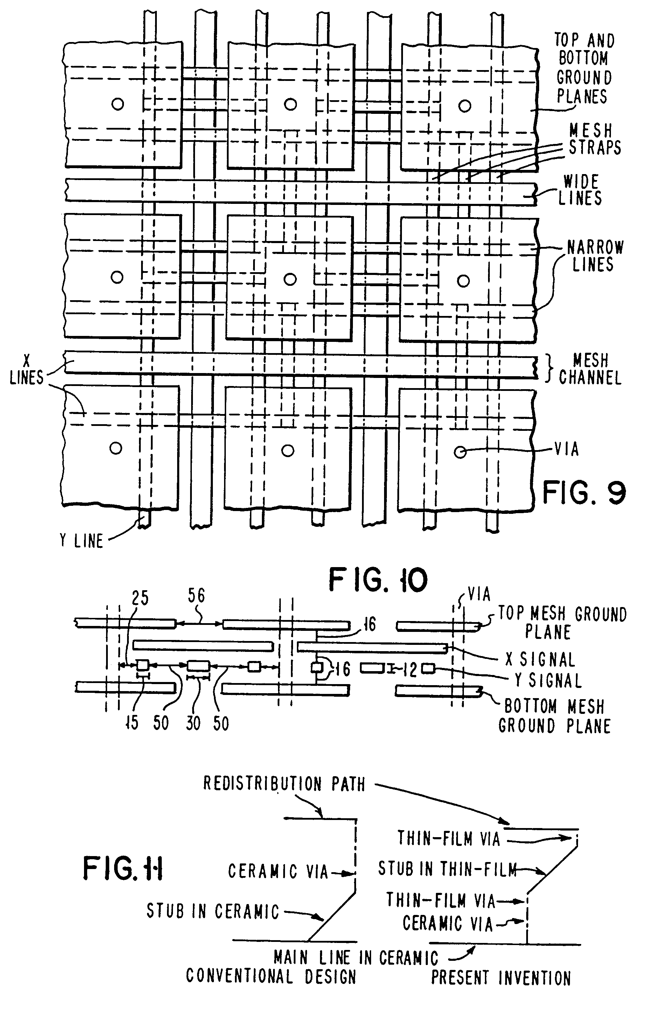

The characteristic impedance for the narrow and wide lines is maintained the same by opening regularly spaced channels in the two thin film reference planes above and below the wide line channel locations, creating a pseudo-mesh as shown in Figs. 8 and 9. The islands in the planes are interconnected by conductive straps that maintain good DC conductivity, and provide a low inductance return path for the narrow lines but do not capacitively load the wide lines to reduce their impedance. The straps also help shield the X and Y lines from noises generated in the adjacent layers. The thickness of the dielectric layers, which is a key parameter determining Zo, is then dictated by the narrow lines. For 15 and 30 µm wide lines and solid reference planes, a dielectric layer thickness of 25-37 µm would be required to obtain a characteristic impedance close to 50 Ω. Such thick layers would be difficult to process. The mesh-reference design described above and shown in Figs. 8 and 9 allows the use of thinner, more easily fabricated, dielectric layers, while maintaining the same impedance for both the narrow and wide lines.

Fig. 10 depicts a possible cross section for a C4 and thin-film via pitch of 225 µm. The narrow lines are 15 µm wide and 12 µm thick, providing a DC line resistance of 1.1 Ω / cm using copper metallurgy (resistivity of approximately 2.0 µΩcm). The wide lines are 30 µm wide and 12 µm thick, providing a DC line resistance of 0.55 Ω / cm. The use of a 56 µm wide opening in the mesh reference planes above and below the wide line channels reduces the dielectric layer thickness to 16 µm while resulting in 45 and 47 Ω impedance for the wide and narrow lines respectively. The worst case coupling for the two types of lines are Kb = 5.6% and Kb = 4.1%, respectively, (calculated using the technique of reference 3). This crosstalk is lower than typically found in the ceramic wiring.

As a consequence of the above design features, signal lines that employ both narrow and wide line sections will be matched, reducing reflections, allowing faster signal risetimes and thus shorter cycle times. With the design described above the same driver circuit can be used for both wide and narrow lines. The relatively high impedance of both types of lines require less current drive and therefore lower circuit power.

Fig. 11 shows the benefit of having a Hybrid wiring structure in the case of multi-drop nets (one driver with more than one receiver). In an all-ceramic wiring structure, which has a coarse via grid, nets with one driver and multiple receivers use up via positions which would otherwise be used for power distribution. Due to the coarse via grid the stubs of the multiple receivers are often quite long. The increased length of the stubs, coupled with the higher dielectric constant of the ceramic leads to a high capacitive discontinuity. The large stub discontinuity causes reflections that prevents the propagation of faster risetime signals and thus reduces the overall machine cycle time. The multi-drop nets in the hybrid module can be wired where the mainline of the net is wired in the ceramic and the stubs are wired with thin-film segments. This reduces the number of ceramic vias required to wire the net, therefore freeing up the ceramic vias for power distribution. Because of the lower εᵣ in the thin-film region, this also greatly reduces the stub capacitive discontinuity, therefore providing better signal integrity and allows faster signal risetimes for overall improved machine performance.

The proposed invention offers an optimum electronic packaging solution. The use of the hybrid module offers the best of both ceramic and thin-film technologies. The ceramic offers a low resistance and inductance power distribution system, while the thin-film offers increased wireability in a faster propagation medium with both low and high resistance transmission lines. The use of the proposed design offers 100% EC'ability, dead zone wiring for power and signal utilization, low capacitive discontinuities for multi-drop nets and a single design for applications not requiring the performance of a thin-film plane pair for chip to chip interconnections.

## Claims

1. A hybrid semiconductor module comprising a base element structure composed of ceramic material for voltage distribution and signal interconnection functions, a thin-film structure disposed on said base element structure, said thin film structure having a plurality of thin-film wiring layers including a normalization layer in contact with said ceramic layer, at least first and second ground plane layers, at least a first signal layer containing thin-film wiring disposed in the X direction, at least a second signal layer containing thin-film wiring disposed in the Y direction orthogonal to said X direction, and a top surface layer.

2. A hybrid semiconductor module according to claim 1 wherein said at least first signal layer contains wide signal lines and narrow signal lines in said X direction and said at least second signal layer contains wide signal lines and narrow signal lines in said Y direction, and wherein said narrow signal lines have an electrical resistance greater than said wide signal lines.

3. A hybrid semiconductor module according to claim 1 or 2 wherein said thin-film structure includes at least one pseudo-mesh thin-film plane proximate to said wide lines for providing uniform characteristic impedance for said narrow and said wide lines.

4. A hybrid semiconductor module according to any one of claims 1 to 3 wherein said thin-film structure includes two pseudo-mesh thin-film plane respectively disposed above and below said wide lines for providing said uniform characteristic impedance.

5. A hybrid semiconductor module according to claim 2 wherein said wide signal lines are twice the width of said narrow signal lines, and the resistance value of said narrow signal lines are twice the resistance value of said wide signal lines, and wherein said wide lines and said narrow lines have the same characteristic impedance.

6. A hybrid semiconductor module according to any one of claims 1 to 5 wherein said first and second signal layers are proximate to each other, and both are disposed between said first and second ground plane layers, and wherein said first and second signal layers and said first and second ground planes are disposed between said normalization layer and said top surface layer.

7. A hybrid semiconductor module according to claim 6 further including a plurality of via connections extending from said ceramic base, through said normalization layer, said ground plane layers, said first and second signal layers, and said top surface layer to provide interconnections between said layers.

8. A hybrid semiconductor module according to claim 7 wherein said top surface layer and said normalization layer contain redistribution wiring.

9. A hybrid semiconductor module according to claim 6 wherein said normalization layer includes both lines for signal redistribution and line for power redistribution.

10. A hybrid semiconductor module according to any one of claims 7 to 9 further including thin-film vias extending from said ceramic base to thin-film stubs for connecting said thin-film stubs with ceramic lines for reducing stub capacitance.
